# EUROPEAN PATENT APPLICATION

(11) **EP 3 046 214 A1**
(43) Date of publication of application: **20.07.2016**
(21) Application number: 13892276.0
(22) Date of filing: 31.12.2013
(51) Int. Cl.: H02J 9/06, H02J 7/00, F21S 9/03, F21Y 101/00

(54) **SOLAR POWER SUPPLY DEVICE AND SOLAR ILLUMINATION DEVICE**

(30) Priority: 28.08.2013 CN 201320530322 U
(71) Applicant: Kmc Industries Ltd., Guangzhou, Guangdong 510000 (CN)
(72) Inventor: LIU, Zihui, Guangzhou Guangdong 510000 (CN); WANG, Yongli, Guangzhou Guangdong 510000 (CN); HU, Shengwen, Guangzhou Guangdong 510000 (CN); HUANG, Ruichao, Guangzhou Guangdong 510000 (CN)
(74) Representative: Isern-Jara, Nuria
(86) International application number: PCT/CN2013/091106
(87) International publication number: WO 2015/027653

(57) **Abstract**

A solar power supply device includes: a solar power supply module (110), a solar power supply switch (20), a light sensing module (310), a control circuit (40), a power supply interface (50) and an external power interface switch (60). The solar power supply module (110) is connected with the power supply interface (50) through the solar power supply switch (20). The light sensing module (310) is connected with the control circuit (40). The power supply interface (50) is connected with an external power source through the external power interface switch (60). The control circuit (40) controls the on/off of the solar power supply switch (20) and the external power interface switch (60) on the basis of the electric signal of the light sensing module (310) and the voltage value of the solar power supply module (110). Additionally, also provided is a solar illumination device having the functions of being powered by the solar energy and an external standby power source, so that not only the solar energy can be fully used, but also the power supply device can provide a steady power source energy in all-weather and without the limit of the seasons and the illumination device can be used in all-weather and without the limit of the seasons.

## Description

### Technical Field

The present application relates to solar technologies, especially to a solar power supply device and solar lighting equipment.

### Background

Solar energy is a novel energy source with increasing applications. Application of solar energy may reduce carbon emission and pollution, improving global environment, and thus won attention from governments and people of various countries. Solar energy is inexhaustible and has been used in applications of all kinds of industries in recent years. The most prominent application is grid-connected power generation and solar lighting, especially in the lighting industries.

Prior solar lighting technologies mainly consist of solar cell, photosensitive device, rechargeable battery, light source (LED) and lamp body parts. During the daytime, the solar cell transforms solar energy from solar radiation to electric energy and stores it in the rechargeable battery. During the night time with no solar radiation, the light source is powered by the rechargeable battery and the charging stops after the daybreak.

In practice, solar energy is limited by climate and seasons, which affects the receiving and usage of solar energy at the Earth's surface. Very limited amount of solar radiation is received during cloudy or rainy days. High-latitude areas only have weak sunlight in winter with small amount of solar energy to be captured. As a result, prior solar lighting technology may easily fail to provide sustained and steady lighting. Therefore, such technology is difficult in all-weather implementation and can hardly be used regularly in winter in high-latitude areas, making it impossible to promote its application across the world.

### Summary of the Invention

Therefore, it is necessary to provide a solar power supply device and a solar lighting equipment to overcome the problem in the prior solar lighting technologies that solar lighting cannot provide sustained and steady lighting.

A solar power supply device is disclosed, comprising: a solar power supply module, a solar power supply switch, a photosensitive module, a control circuit, a power supply port, and an external power supply port switch; wherein
the solar power supply module is connected to the power supply port via the solar power supply switch;
the photosensitive module is connected to the control circuit;
the power supply port is connected to an external power supply via the external power supply port switch; and
the control circuit controls the switching of the solar power supply switch and the external power supply port switch according to electrical signals from the photosensitive module and voltage values of the solar power supply module.

The solar power supply device described above may use a solar power supply and also connect to an external power supply at the same time. Under normal conditions, it may use both solar energy and external power supply as sources for supplying power to provide maximum power supply. Under insufficient solar energy, the solar power supply is switched off to protect the battery. This power supply device may ensure sustained and steady lighting, making full of solar energy, and be used anywhere under all-weather conditions, without being limited by seasons.

The solar power supply device described above may function as a solar power supply and also connect to an external power supply at the same time. Under normal conditions, it may use solar energy or external power supply or a hybrid power from both as sources for supplying power. Under insufficient solar energy, the external power supply is used as power supplying source so as to ensure maximum energy output.

A solar lighting equipment is also disclosed, comprising: a solar power supply module, a solar power supply switch, a photosensitive module, a control circuit, a power supply port, a LED driver module, and a LED light source; wherein
the solar power supply module is connected to the LED driver module via the solar power supply switch;
the LED driver module is connected to the LED light source;
the photosensitive module is connected to the control circuit; and
the control circuit controls the switching of the solar power supply switch and the external power supply port switch according to electrical signals from the photosensitive module and voltage values of the solar power supply module.

The solar power supply device described above may use a solar power supply and also connect to an external power supply at the same time. Under normal conditions, it may use both solar energy and external power supply as sources for supplying power to provide maximum power supply. Under insufficient solar energy, the solar power supply is switched off to protect the battery. This power supply device may ensure sustained and steady lighting, making full of solar energy, and be used anywhere under all-weather conditions, without being limited by seasons.

The solar lighting equipment described above may use a solar power supply and also connect to an external power supply at the same time. Under normal conditions, it may use solar energy or external power supply or a hybrid power from both as sources for supplying power. Under insufficient solar energy, the external power supply is used as power supplying source so as to ensure maximum energy output.

### Brief Description of Drawings

Figure 1 shows a structural schematic diagram of a solar power supply device according to one of the embodiments.
Figure 2 shows a structural schematic diagram of a solar power supply device according to one of the preferred embodiments.
Figure 3 shows a structural schematic diagram of a solar lighting equipment according to one of the embodiments.
Figure 4 shows a structural schematic diagram of a solar lighting equipment according to one of the preferred embodiments.
Figure 5 shows a structural schematic diagram of a solar lighting system according to one of the embodiments.

### Detailed Description of Embodiments

The embodiments of the solar power supply device of the present application will be described in details with references to the figures.

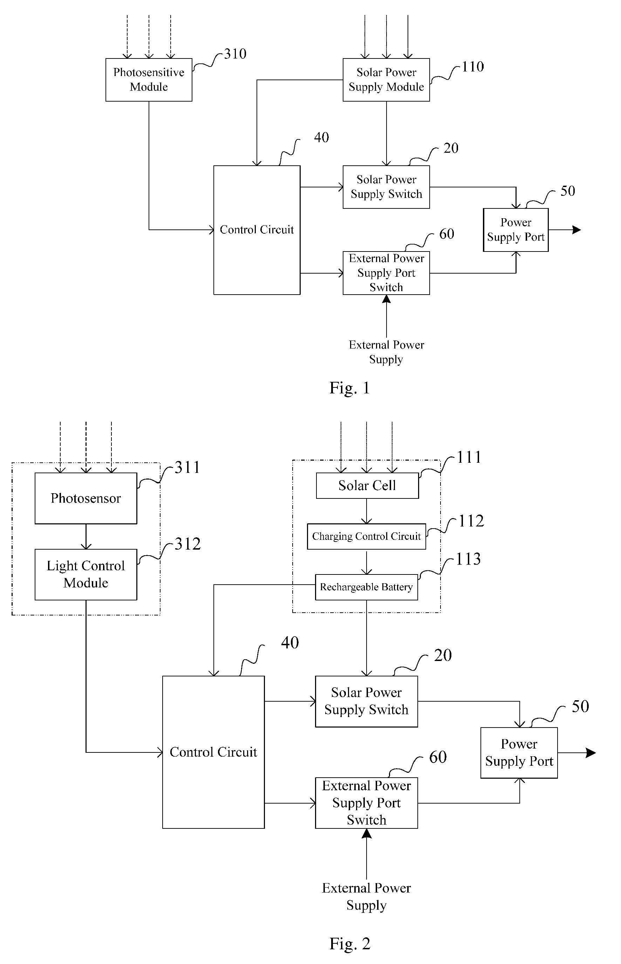

As shown in Figure 1, in one of the embodiments, a structural schematic diagram of a solar power supply device, comprising a solar power supply module 110, a solar power supply switch 20, a photosensitive module 310, a control circuit 40, a power supply port 50, and an external power supply port switch 60.

The solar power supply module 110 is connected to the power supply port 50 via the solar power supply switch 20. The photosensitive module 310 is connected to the control circuit 40. The power supply port 50 is connected to an external power supply via the external power supply port switch 60.

In operation, the control circuit 40 controls the switching of the solar power supply switch 20 and the external power supply port switch 60 according to electrical signals from the photosensitive module 310 and voltage values of the solar power supply module 110.

During the day time, the control circuit 40 switches off the solar power supply switch 20 and the external power supply port switch 60 according to the electric signals from the photosensitive module 310. During the night time, the solar power supply switch 20 is switched on and the external power supply port switch 60 is switched off. When the voltage values of the solar power supply module 110 are lower than a certain value, indicating insufficient power of the solar power supply, the control circuit 40 controls the external power supply port switch 60 to switch on so that the backup external power supply (e.g., AC) may be used to supply power to the power supply port 50 to realize continuous power supply.

During the day time, the control circuit 40 switches off the solar power supply switch 20 and the external power supply port switch 60 according to the electric signals from the photosensitive module 310. During the night time, the solar power supply switch 20 and the external power supply port switch 60 are first switched on. When the voltage values of the solar power supply module 110 are lower than a certain value, indicating insufficient power of the solar power supply, the control circuit 40 switches off the solar power supply switch 20 to protect the battery with the external power supply becoming the sole power supply source.

The device of the present application, connecting to a backup external power supply via the external power supply port switch 60, which may connect to the backup external power supply anytime while supplying power with solar energy. In this way, solar energy as a clean energy source is taken full advantage of while a maximum energy output is ensured. This power supply device may be used anywhere under all-weather conditions, without being limited by seasons.

The device of the present application, connecting to a backup external power supply via the external power supply port switch 60, supplies power with solar energy and the external power supply simultaneously. In this way, solar energy as a clean energy source is taken full advantage of while a maximum energy output is ensured. This power supply device may be used anywhere under all-weather conditions, without being limited by seasons.

Now refer to Figure 2, which shows a structural schematic diagram of a solar power supply device according to one of the preferred embodiments.

In one of the embodiments, the solar power supply module 110 comprises a solar cell 111, a charging control circuit 112, and a rechargeable battery 113 connected in sequence, wherein the rechargeable battery 113 is connected to the solar power supply switch 20.

In this embodiment, the solar cell 111 converts solar energy to electric power, charging the rechargeable battery 113 via the charging control circuit 112, which may prevent overcharging of the rechargeable battery 113 by controlling the charging current and voltage.

In one of the embodiments, the photosensitive module 310 comprises a photosensor 311 and a light control module 312 connected to each other, wherein the light control module 312 is connected to the control circuit 40.

In this embodiment, when there is light during the day time, the photosensor 311 can sense the light, and the light control module 312 outputs a signal indicating strong radiance to the control circuit 40. The control circuit 40, when receiving the signal indicating strong radiance, switches off the solar power supply switch 20 and the external power supply port switch 60, stopping the power supply port 50 from supplying electricity.

When the night comes, the photosensor 311 senses a drop in the radiance, and the light control module 312 outputs a signal indicating low radiance to the control circuit 40. The control circuit 40, when receiving the signal indicating low radiance, examines whether the voltage of rechargeable battery 113 is higher than a preset value. Higher voltage than the preset value indicates sufficient power stored in the rechargeable battery 113, in which case the solar power supply switch 20 switches on to the rechargeable battery 113 so that power is supplied from the rechargeable battery 113 to the power supply port 50. Meanwhile, the external power supply port switch is switched on so that power is supplied from the external power supply to the power supply port 50.

During the power supplying process, the control circuit 40 may continuously detect the voltage of the rechargeable battery 113. When the voltage of the rechargeable battery 113 is lower than a preset value, the control circuit 40 controls the solar power supply switch 20 to switch off from the rechargeable battery 113. Then, only the external power supply port switch 60 is connected to the external power supply so that power is supplied only from the external power supply to the power supply port 50.

During the power supplying process, the control circuit 40 continuously detects the voltage of the rechargeable battery 113. When the voltage of the rechargeable battery 113 is lower than a preset value, the control circuit 40 controls the solar power supply switch 20 to switch off from the rechargeable battery 113. Then, only the external power supply port switch 60 is connected to the external power supply so that power is supplied only from the external power supply to the power supply port 50.

After the daybreak, the photosensor 311 can sense the light, and the light control module 312 outputs a signal indicating strong radiance to the control circuit 40. The control circuit 40, when receiving the signal indicating strong radiance, switches off the solar power supply switch 20 and the external power supply port switch 60, stopping the power supply port 50 from supplying electricity.

The solar power supply device described above may use a solar power supply and also connect to an external power supply at the same time. Under normal conditions, it may use both solar energy and external power supply as sources for supplying power to provide maximum power supply. Under insufficient solar energy, the solar power supply is switched off to protect the battery. This power supply device may ensure sustained and steady lighting, making full of solar energy, and be used anywhere under all-weather conditions, without being limited by seasons.

The device of the present application, connecting to a backup external power supply via the external power supply port switch 60, supply power with solar energy and the external power supply simultaneously. In this way, solar energy as a clean energy source is taken full advantage of while a maximum energy output is ensured. This power supply device may be used anywhere under all-weather conditions, without being limited by seasons.

The embodiments of the solar lighting equipment of the present application will be described in details with references to the figures.

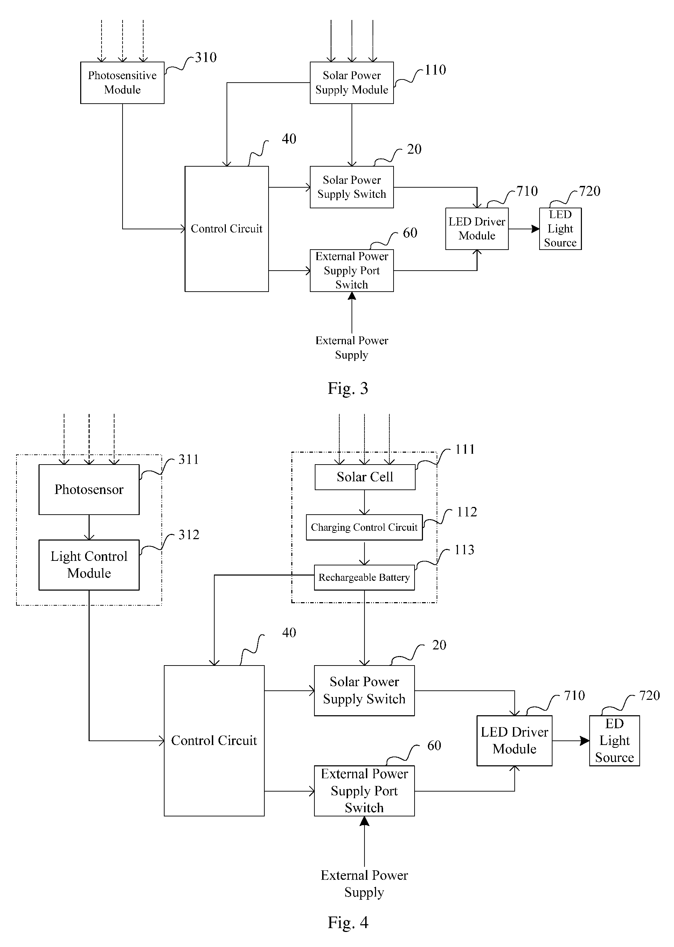

As shown in Figure 3, in one of the embodiments, a structural schematic diagram of a solar lighting equipment, comprising a solar power supply module 110, a solar power supply switch 20, a photosensitive module 310, a control circuit 40, a power supply port 50, a LED driver module 710, and a LED light source 720 (light emitting diode).

The solar power supply module 110 is connected to the LED driver module 710 via the solar power supply switch 20. The LED driver module 710 is connected to the LED light source720. The photosensitive module 310 is connected to the control circuit 40.

In operation, the control circuit 40 controls the switching of the solar power supply switch 20 and the external power supply port switch 60 according to electrical signals from the photosensitive module 310 and voltage values of the solar power supply module 110.

During the daytime, the control circuit 40 switches off the solar power supply switch 20 and the external power supply port switch 60 to stop supplying power to the LED driver module 710. During the night, the solar power supply switch 20 is switched on and the external power supply port switch 60 is switched off. When the voltage of the solar power supply module 110 is lower than a certain value, indicating insufficient electric power from the solar energy, the control circuit 40 controls external power supply port switch 60 to switch on and uses on the backup external power supply (e.g., AC) to supply power to the LED driver module 710, driving the LED driver module 710 to realize continuous lighting.

During the daytime, the control circuit 40 switches off the solar power supply switch 20 and the external power supply port switch 60 to stop supplying power to the LED driver module 710. During the night, the solar power supply switch 20 and the external power supply port switch 60 are both switched on. When the voltage of the solar power supply module 110 is lower than a certain value, indicating insufficient electric power from the solar energy, the control circuit 40 switches off the solar power supply switch 20 and uses only the backup external power supply (e.g., AC) to supply power to the LED driver module 710, driving the LED light source 720 to realize continuous lighting.

Now refer to Figure 4, which shows a structural schematic diagram of a solar lighting equipment according to one of the preferred embodiments.

In one of the embodiments, the solar lighting equipment 110 comprises a solar cell 111, a charging control circuit 112, and a rechargeable battery 113 connected in sequence, wherein the rechargeable battery 113 is connected to the solar power supply switch 20.

In this embodiment, the solar cell 111 converts solar energy to electric power, charging the rechargeable battery 113 via the charging control circuit 112, which may prevent overcharging of the rechargeable battery 113 by controlling the charging current and voltage.

In one of the embodiments, the photosensitive module 310 comprises a photosensor 311 and a light control module 312 connected to each other, wherein the light control module 312 is connected to the control circuit 40.

In this embodiment, when there is light during the day time, the photosensor 311 can sense the light, and the light control module 312 outputs a signal indicating strong radiance to the control circuit 40. The control circuit 40, when receiving the signal indicating strong radiance, switches off the solar power supply switch 20 and the external power supply port switch 60, stopping supplying electricity to the LED driver module 710 and the LED light source 720 is off.

When the night comes, the photosensor 311 senses a drop in the radiance, and the light control module 312 outputs a signal indicating lower radiance to the control circuit 40. The control circuit 40, upon receiving the signal indicating lower radiance, examines whether the voltage of rechargeable battery 113 is higher than a preset value. Higher voltage than the preset value indicates sufficient power stored in the rechargeable battery 113, in which case the solar power supply switch 20 switches on to the rechargeable battery 113 so that power is supplied from the rechargeable battery 113 to the LED driver module 710 and the LED light source 720 is on.

During the power supplying process, the control circuit 40 continuously detects the voltage of the rechargeable battery 113. When the voltage of the rechargeable battery 113 is lower than a preset value, the control circuit 40 controls the solar power supply switch 20 to switch off from the rechargeable battery 113. Meanwhile, only the external power supply port switch 60 is connected to the external power supply so that power is supplied from the external power supply to the LED driver module 710 to maintain the lightening status of the LED light source 720.

During the power supplying process, the control circuit 40 continuously detects the voltage of the rechargeable battery 113. When the voltage of the rechargeable battery 113 is lower than a preset value, the control circuit 40 controls the solar power supply switch 20 to switch off from the rechargeable battery 113. Then, only the external power supply port switch 60 is turned on and connected to the external power supply so that power is supplied from the external power supply to the LED driver module 710 to maintain the lightening status of the LED light source 720.

After the daybreak, the photosensor 311 can sense the light, and the light control module 312 outputs a signal indicating strong radiance to the control circuit 40. The control circuit 40, when receiving the signal indicating strong radiance, switches off the solar power supply switch 20 and the external power supply port switch 60, stopping supplying electricity to the LED driver module 710 and the LED light source 720 is off.

The solar lighting equipment described above may use a solar power supply and also connect to a backup external power supply at the same time. Under normal conditions, it may use solar energy as sources for supplying power. Under insufficient solar energy, the backup external power supply is used as the power supply for lightening. This power supply device may ensure sustained and steady lighting, making full of solar energy, and be used anywhere under all-weather conditions, without being limited by seasons.

The solar lighting equipment described above may use a solar power supply and also connect to an external power supply at the same time. Under normal conditions, it may use solar energy or external power supply or a hybrid power from both as sources for supplying power to provide maximum power supply. Under insufficient solar energy, the solar power supply is switched off to protect the battery. This power supply device may ensure sustained and steady lighting, making full of solar energy, and be used anywhere under all-weather conditions, without being limited by seasons.

To further clarify the technical solution of the present application, an example embodiment is described below.

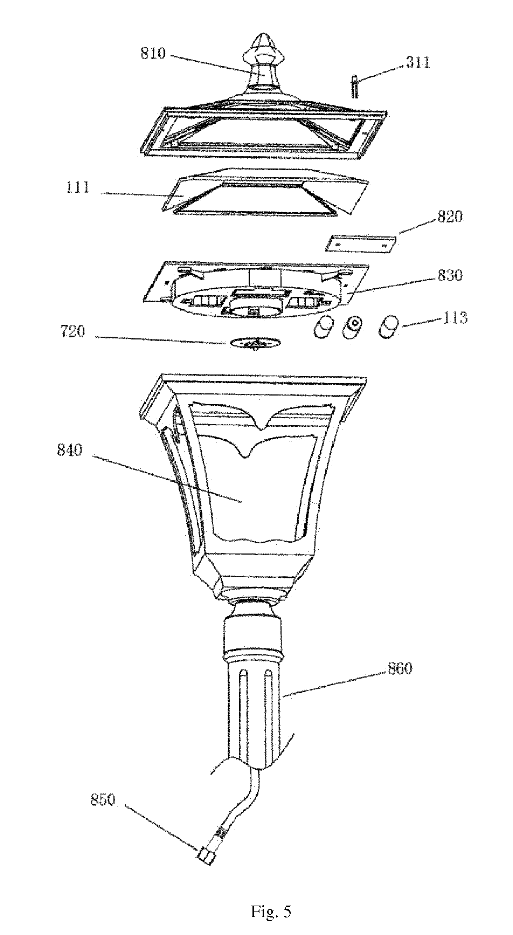

Now refer to Figure 5, which shows a structural schematic diagram of a solar power supply device or a solar lighting equipment according to the present application, substantially comprising: a lamp top cover 810, a photosensor 311, a solar cell 111, a control circuit board 820, an electric appliance holder830, a rechargeable battery 113, a LED light source 720, a lampshade 840, an external power supply port 850, and a lamp post 860, wherein the control circuit board 820 integrated on it a charging control circuit 112, a light control module 312, a LED driver module 710, a control circuit 40, and a external power supply port switch 60.

In this example, the photosensor 311 and the solar cell 111 are mounted on the lamp top cover 810 and undergo waterproof treatment. The solar cell 111 is exposed upwards to receive the sunlight.

The control circuit board 820, the rechargeable battery 113, and the LED light source 720 are mounted and fixed to the electric appliance holder 830, which is connected to the top cover via fasteners. The photosensor 311, the solar cell 111, the rechargeable battery 113, and the LED light source 720 are connected to the control circuit board 820 via wires. The components described above form together a lamp socket assembly.

The lamp socket assembly is connected to the lampshade 840 and the lamp post 860. The external power supply port 850 is connected to the control circuit board 820 via a wire through the internal edge of the lampshade 840 and the electric appliance holder 830.

The solar lighting system of this example can work under all weather operations as long as it is placed under the sun and connected to an external power supply.

The detailed embodiments described herein are only for the purpose of illustrating the present invention, and are not intended to limit the scope of the present invention in any way. It would be understand by a person skilled in the art that various changes and modifications can be made to the embodiments described herein without departing from the scope and spirit of the present invention. Such changes and modifications are contemplated by the present invention, the scope of which should only be defined by the following claims.

## Claims

1. A solar power supply device, comprising: a solar power supply module, a solar power supply switch, a photosensitive module, a control circuit, a power supply port, and an external power supply port switch; wherein
the solar power supply module is connected to the power supply port via the solar power supply switch;
the photosensitive module is connected to the control circuit;
the power supply port is connected to an external power supply via the external power supply port switch; and
the control circuit is configured to control the switching of the solar power supply switch and the external power supply port switch according to electrical signals from the photosensitive module and voltage values of the solar power supply module.

2. The solar power supply device according to Claim 1, wherein the solar power supply module comprises a solar cell, a charging control circuit, and a rechargeable battery connected in sequence, and wherein the rechargeable battery is connected to the solar power supply switch.

3. The solar power supply device according to Claim 1, wherein the photosensitive module comprises a photosensor and a light control module connected to each other, and wherein the light control module is connected to the control circuit.

4. A solar lighting equipment, comprising: a solar power supply module, a solar power supply switch, a photosensitive module, a control circuit, a power supply port, a LED driver module, and a LED light source; wherein
the solar power supply module is connected to the LED driver module via the solar power supply switch;
the LED drive module is connected to the LED light source;
the photosensitive module is connected to the control circuit; and
the control circuit controls the switching of the solar power supply switch and the external power supply port switch according to electrical signals from the photosensitive module and voltage values of the solar power supply module.

5. The solar lighting equipment according to Claim 4, wherein the solar power supply module comprises a solar cell, a charging control circuit, and a rechargeable battery connected in sequence, and wherein the rechargeable battery is connected to the solar power supply switch.

6. The solar lighting equipment according to Claim 4, wherein the photosensitive module comprises a photosensor and a light control module connected to each other, and wherein the light control module is connected to the control circuit.
